# EUROPEAN PATENT APPLICATION

(11) **EP 2 369 249 A2**
(43) Date of publication of application: **28.09.2011**
(21) Application number: 11155925.8
(22) Date of filing: 25.02.2011
(51) Int. Cl.: F24F 3/044, F24F 11/00, H05K 7/20

(54) **Air conditioning system**

(30) Priority: 12.03.2010 JP 2010056582
(71) Applicant: FUJITSU LIMITED, Kawasaki-shi, Kanagawa 211-8588 (JP)
(72) Inventor: Ishimine, Junichi, Kawasaki-shi, Kanagawa 211-8588 (JP); Ohba, Yuji, Kawasaki-shi, Kanagawa 211-8588 (JP); Nagamatsu, Ikuro, Kawasaki-shi, Kanagawa 211-8588 (JP)
(74) Representative: Stebbing, Timothy Charles

(57) **Abstract**

An air conditioning system (I) includes an air conditioner (3; 10; 10A) that feeds cooling air to a space in which an electronic device (2) is arranged; and a supplying opening (4; 30; 30A; 30B; 40) that is provided in a vicinity of a flow pathway along which hot air discharged from the electronic device (2) flows to be drawn in into the electronic device (2), and that supplies the cooling air fed by the air conditioner (3; 10; 10A).

## Description

The present invention relates to an air conditioning system in which cooling air fed from an air conditioner is supplied to an electronic device and hot air, discharged from the electronic device, is drawn in by the air conditioner.

Recently, a data center in which a plurality of racks each stacking electronic devices such as a server and networking equipment has been known. An electronic device has functional parts such as a central processing unit (CPU) and generates heat when the functional parts consume electric power to fulfill functions. Therefore, an air conditioning system in which cooling air is fed from an air conditioner to cool the electronic devices has been used for cooling the heat generated by the electronic devices.

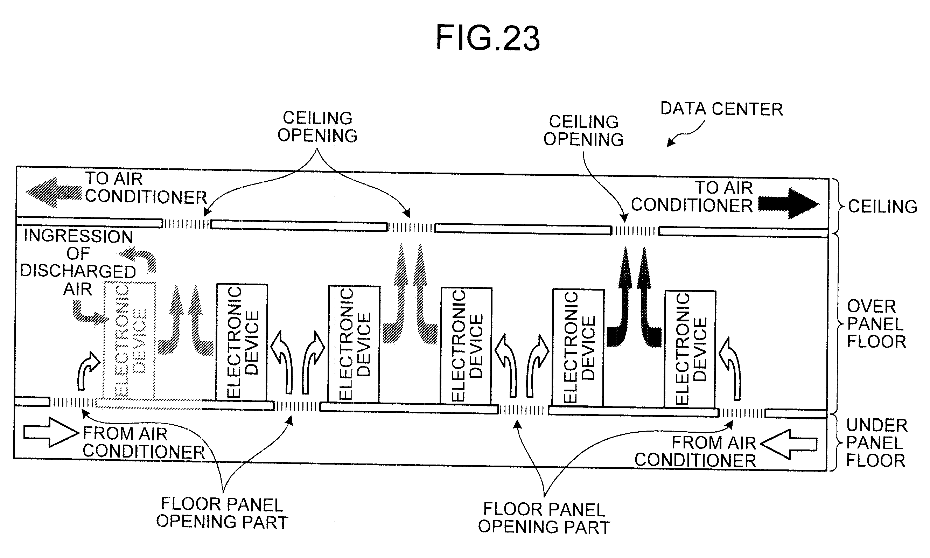

Here, a configuration of an air conditioning system will be explained with reference to FIG. 23. FIG. 23 is an explanatory view of a conventional air conditioning system. As illustrated in FIG. 23, the air conditioning system has a dual floor structure having an over-panel floor and an under-panel floor and electronic devices are arranged on the over-panel floor.

With this configuration, cooling air fed from a not illustrated air conditioner to a space over the under-panel floor is supplied to the electronic devices on the over-panel floor by way of a floor panel opening part and hot air discharged from the electronic devices is drawn in into the air conditioner by way of a ceiling opening part in the air conditioning system. Here in FIG. 23, a white arrow indicates a flow of the cooling air and a black arrow indicates a flow of the discharged hot air.

In the data center with this configuration, a "discharged air ingression" which means that electronic devices draw in the hot air discharged from the electronic devices occurs when an air volume coming out of the air conditioner is insufficient. In the example of FIG. 23, the discharged air ingression occurs in the electronic device placed on the far left in the data center.

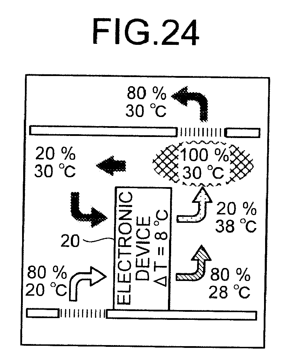

Here, a flow of the cooling air and the discharged hot air in the data center will be explained specifically by using an example illustrated in FIG. 24. FIG. 24 is an explanatory view of an air volume, a supplied air (indrawn air) temperature, and a discharged air temperature in the conventional air conditioning system. The example of FIG. 24 is configured such that cooling air at 20°C is supplied from the space over the under-panel floor to an electronic device intake air/discharged air temperature difference of which is 8°C (the electronic device being illustrated in FIG. 24 as "electronic device AT = 8°C") with an air volume equivalent to 80% of an air volume required by the electronic device and there is an insufficiency in volume of the cooling air by 20%.

As illustrated in FIG. 24, the electronic device to which the cooling air at 20°C is supplied from the space over the under-panel floor discharges hot air at 28°C. Here in the example of FIG. 24, since a cooling air volume required by the electronic device is insufficient by 20%, the "discharged air ingression" occurs, and an air volume equivalent to 20% required by the electronic device out of the hot air discharged by the electronic device goes to an air intake surface of the electronic device and is supplied to the electronic device.

As a result of this, hot air at 38°C is discharged from the electronic device, a temperature of the discharged hot air to be drawn in at an upper part of the rack becomes as high as 30°C, a temperature of functional parts in an inside of the electronic device goes up, and a reliability of the electronic device deteriorates. Therefore, a method of increasing a cooling air volume to be fed from an air conditioner is adopted to prevent the discharged air ingression. Detailed information of the conventional technique will be obtained in Japanese Laid-open Patent Publication No. 2006-64303, Japanese Laid-open Patent Publication No. H8-303815, and Japanese Laid-open Patent Publication No. 2004-184070.

However, there has been a problem of causing a large electric power consumption as a result of increasing a cooling air volume to be fed from an air conditioner for supplying sufficient cooling air to the electronic device in the method of preventing the discharged air ingression described above.

The present invention has been achieved in view of the problem in the conventional technique described above. That is, it is desirable to suppress a cooling air volume to be fed from an air conditioner and to reduce an electric power consumption.

According to an aspect of an embodiment of the invention, an air conditioning system includes an air conditioner that feeds cooling air to a space in which an electronic device is arranged; and a supplying opening (supply opening) that is provided in a vicinity of a flow pathway along which hot air discharged from the electronic device flows to be drawn in into the electronic device and supplies the cooling air fed by the air conditioner.

Reference is made, by way of example only, to the accompanying drawings in which:
FIG. 1 is a block diagram of a configuration of an air conditioning system according to a first embodiment;
FIG. 2 is a block diagram of an arrangement of racks and air conditioners in a data center according to a second embodiment;
FIG. 3 is a block diagram of a configuration of the data center according to the second embodiment;
FIG. 4 is an explanatory view of an air volume, a supplied air temperature, and a discharged air temperature in a data center;
FIG. 5 is an explanatory view of an air volume, a supplied air temperature, and a discharged air temperature in a data center;
FIG. 6 is an explanatory view of a discharged air ingression preventive structure provided at a lower part of a rack;
FIG. 7 is an explanatory view of a rack side partition in a hot aisle;
FIG. 8 is an explanatory view of a configuration of a data center including air conditioners;
FIG. 9 illustrates a result of a simulation;
FIG. 10 is a block diagram of a configuration of a data center according to a third embodiment;
FIG. 11 illustrates a result of simulation;
FIG. 12 illustrates a result of a simulation;
FIG. 13 illustrates a result of a simulation;
FIG. 14 is a block diagram of a cross section of a configuration of a data center according to a fourth embodiment, the cross section being along a line A-A illustrated in FIG. 16;
FIG. 15 is a block diagram of a cross section of the configuration of the data center according to the fourth embodiment, the cross section being along a line B-B illustrated in FIG. 14;
FIG. 16 is a block diagram of a cross section of the configuration of the data center according to the fourth embodiment, the cross section being along a line C-C illustrated in FIG. 14;
FIG. 17 is a side view of an air conditioner in a data center;
FIG. 18 is a front view of the air conditioner in the data center;
FIG. 19 is an explanatory view of a rack side partition in a hot aisle;
FIG. 20 is an explanatory view of a rack side partition in a hot aisle;
FIG. 21 is a block diagram of a configuration of a data center in which a partition plate is provided at an upper part of a rack;
FIG. 22 is a block diagram of a configuration of a data center provided with temperature sensors;
FIG. 23 is an explanatory view of a conventional air conditioning system; and
FIG. 24 is an explanatory view of an air volume, a supplied air temperature, and a discharged air temperature in the conventional air conditioning system.

Preferred embodiments of an air conditioning system according to the present invention will be explained in detail below with reference to the accompanying drawings.

### [a] First Embodiment

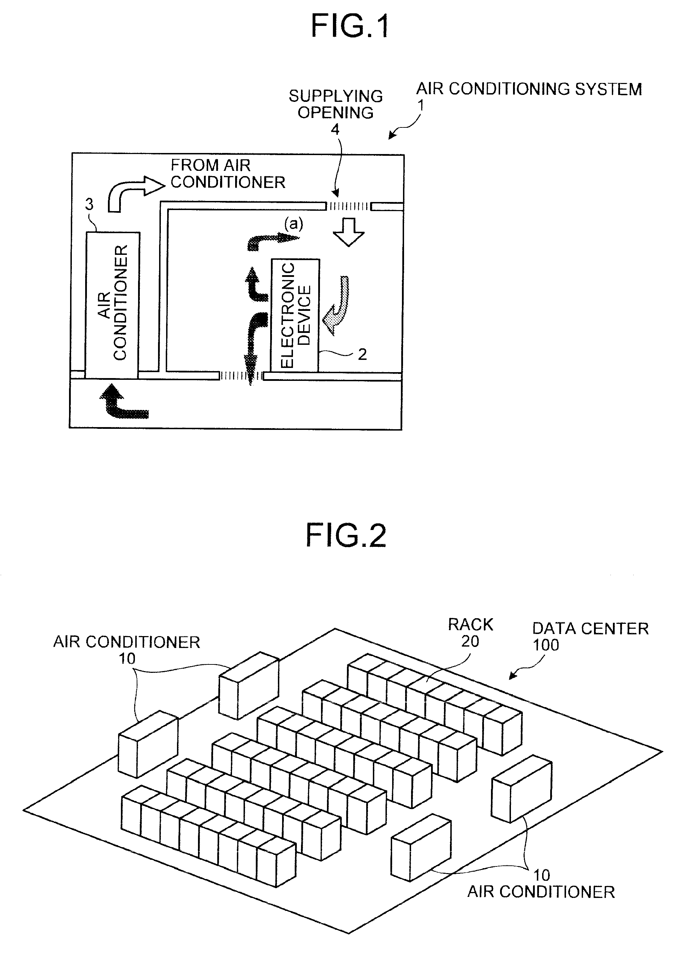

A configuration of an air conditioning system according to a first embodiment will be explained below and advantages according to the first embodiment will be explained last. FIG. 1 is a block diagram of a configuration of an air conditioning system according to a first embodiment. A white arrow indicates a flow of cooling air and a black arrow indicates a flow of discharged hot air. As illustrated in FIG. 1, an air conditioning system 1 according to the first embodiment is provided with an electronic device 2, an air conditioner 3, and a supplying opening (supply opening) 4.

The electronic device 2 draws in cooling air fed from the air conditioner 3 and discharges hot air into a space at the same time. The air conditioner 3 feeds cooling air to the space in which the electronic device 2 is arranged. The supplying opening 4 is provided in the vicinity of a flow pathway (see a point "(a)" in FIG. 1) along which hot air discharged from the electronic device 2 flows to be drawn in into the electronic device 2 and supplies the cooling air fed from the air conditioner 3 into the space.

To put it another way, the hot air discharged from the electronic device 2 and the cooling air fed from the air conditioner 3 are mixed (allowed to mix) and the mixed air of the discharged hot air and the cooling air is supplied to the electronic device 2, so that a cooling air volume to be fed by the air conditioner 3 can be reduced and an electric power consumption can be reduced in the air conditioning system 1.

### [b] Second Embodiment

A configuration and a flow of processes of an air conditioning system according to a second embodiment will be explained in sequence below and advantages according to the second embodiment will be explained last. As for arrows in FIG. 2, a white arrow indicates a flow of cooling air and a black arrow indicates a flow of discharged hot air.

### Configuration Of Air Conditioning System

First, a configuration of an entirety of a data center 100 will be explained with reference to FIG. 2. FIG. 2 is a block diagram of an arrangement of racks and air conditioners in the data center according to the second embodiment. As illustrated in FIG. 2, the data center 100 is provided with a plurality of air conditioners 10 and a plurality of racks 20.

In the data center 100, a plurality of rack rows each of which has a plurality of arranged racks 20 are provided and arranged such that front surface sides thereof face with each other and back surface sides thereof face with each other. The rack 20, on which an electronic device is mounted, draws in air from a front surface and discharges air from a back surface. Here, the electronic device is mounted on the rack 20 so that a front surface of the electronic device is the front surface of the rack 20 and a back surface of the electronic device is the back surface of the rack 20. The air conditioners 10 are arranged at predetermined intervals and feed cooling air to the space in which the racks 20 are arranged. The air conditioners 10 are separated via a not illustrated wall from the area in which the racks 20 are arranged, the cooling air fed from the air conditioners 10 is supplied from a not illustrated ceiling duct to a space over the over-panel floor on which the racks 20 are arranged, and the air conditioners 10 take up hot air from a not illustrated underfloor plenum.

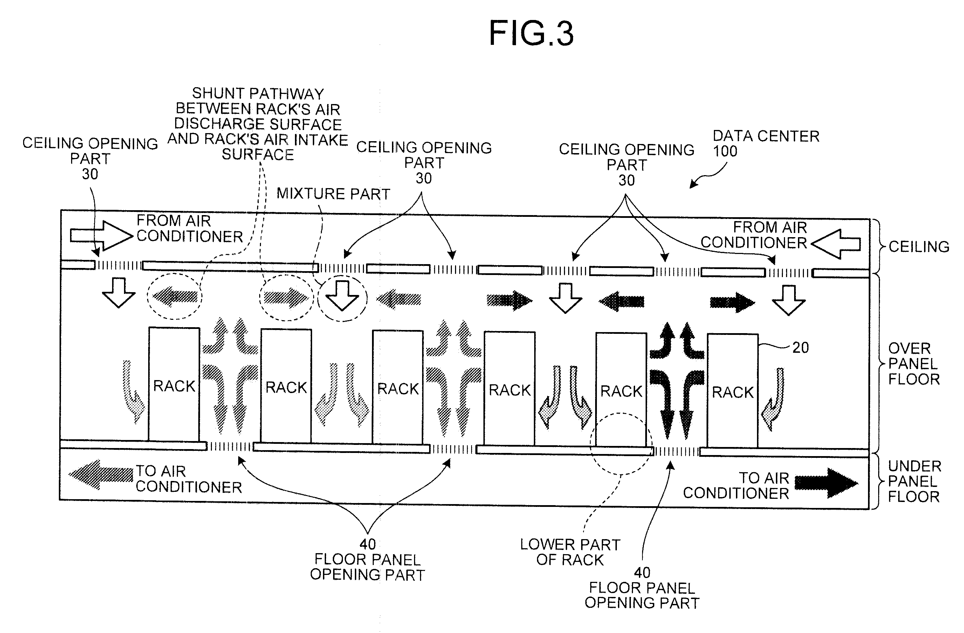

Here, a configuration and an air flow of the data center 100 will be explained with reference to FIG. 3. FIG. 3 is a block diagram of a configuration of the data center according to the second embodiment. As illustrated in FIG. 3, a ceiling opening part 30 is arranged on a ceiling over an aisle in which front surfaces of the racks 20 face with each other and a floor panel opening part 40 is arranged on a floor panel forming a dual floor in an aisle in which back surfaces of the racks 20 face with each other in the data center 100. The air conditioner 10 has an outlet part on an upper surface thereof and an inlet part on a bottom surface thereof.

In the data center 100, there are an air discharge area in the aisle in which the air discharge surfaces of the racks 20 face with each other, an air intake area formed in the aisle in which the air intake surfaces of the racks 20 face with each other, and a shunt part formed in an upper space of the racks 20, the air discharge area being filled with discharged air and the shunt part connecting the air discharge area and the air intake area. The ceiling opening part 30 which supplies the over-panel floor space with the cooling air fed from the air conditioner 10 is provided in the vicinity of the shunt pathway. Here, an air flow will be explained with reference to FIG. 3. As illustrated in FIG. 3, cooling air coming out of the outlet part on upper surface of the air conditioner 10 passes in the ceiling and flows out to a space over the over-panel floor from the ceiling opening part 30 arranged over a cool aisle in which front surfaces of racks face with each other in the data center 100.

Then, the cool air flowing out to the over-panel floor space is drawn in from the front surface of the rack, becomes heated by cooling the electronic device, and is discharged from the back surface of the rack. After that, a part of the heated air discharged from the rack 20 is drawn in from the floor panel opening part 40 arranged on a bottom part of the hot aisle in which the back surfaces of the racks face with each other, passes in the underfloor plenum of the dual floor, and is drawn in from the inlet part on the bottom surface of the air conditioner 10.

When an air flow volume required by the rack 20 is more than a flow volume of the cooling air supplied from the ceiling duct, i.e., when a volume of supplied cooling air is insufficient, a phenomenon in which a part of hot air discharged from the back surface of the rack 20 goes to the front surface of the rack 20 by way of the shunt part formed in the upper space of the rack 20 occurs.

Since the ceiling opening part 30 is provided immediately above the air intake area between the front surfaces of racks, i.e., in the vicinity of the shunt pathway in the second embodiment, the cooling air coming out of the ceiling opening part 30 is mixed in a mixture part with the air discharged at high temperature from the air discharge surface of the rack and thereby air the temperature of which is lower than a target is drawn in by all racks. Hence, an air volume to be fed from the air conditioner in the data center 100 can be reduced by using the air discharged from the rack 20 when a temperature of the air coming out from the air conditioner 10 is below a tolerance of an intake air temperature of the rack.

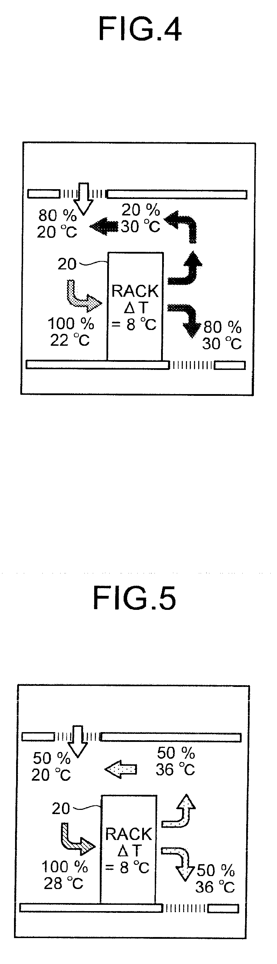

Next, an air volume, a supplied air temperature, and a discharged air temperature in the data center will be explained with reference to FIGS. 4 and 5. FIGS. 4 and 5 are explanatory views of an air volume, a supplied air temperature, and a discharged air temperature in the data center. FIG. 4 represents that air at relatively low temperature can be supplied to an entirety of the racks with an air volume equivalent to 80% of an air volume required by the electronic device.

In the example illustrated in FIG. 4, cooling air at 20°C is fed from a not illustrated air conditioner with an air volume equivalent to 80% of an air volume required by the rack and supplied to the over-panel floor space by way of the ceiling opening part provided in the vicinity of the shunt part which is from the air discharge surface to the air intake surface of the rack. An air volume equivalent to 20% of the discharged air eventually having reached as high as 30°C goes to the front surface side of the rack as an insufficiency, and is mixed with the cooling air at 20°C to be 22°C, and is drawn in by the rack. The temperature of the air drawn in by the rack at 22°C goes up by 8°C in the rack to be 30°C and discharged air equivalent to 80% returns to the not illustrated air conditioner by way of the underfloor plenum from the floor panel opening part.

FIG. 5 represents that an air volume to be fed from the air conditioner which feeds air at 20°C can be suppressed to 50% of the air volume required by the rack when the intake air temperature of the rack is tolerated up to 28°C. The cooling air at 20°C is ejected from the not illustrated air conditioner with an air volume equivalent to 50% of the air volume required by the rack and supplied to the over-panel floor space through the ceiling opening part provided in the vicinity of the shunt part from the air discharge surface to the air intake surface of the rack. An air volume equivalent to 50% of the discharged air eventually having reached as high as 36°C goes to the front surface side of the rack as an insufficiency, is mixed with the cooling air at 20°C to be 28°C, and is drawn in by the rack. The temperature of the air indrawn by the rack at 28°C goes up by 8°C in the rack to be 36°C and the discharged air equivalent to 50% returns to the not illustrated air conditioner by way of the underfloor plenum from the floor panel opening part.

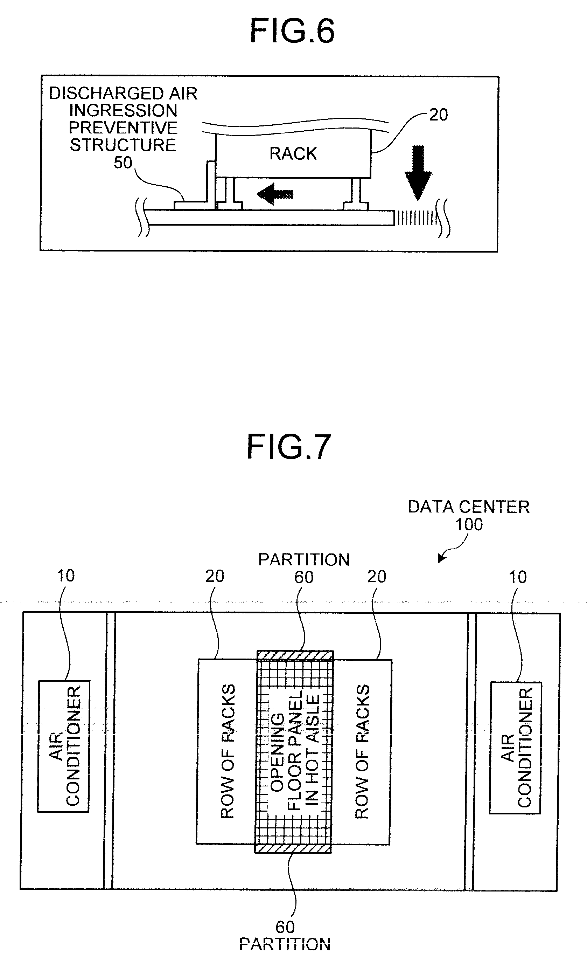

Next, a discharged air ingression preventive structure provided at a lower part of the rack will be explained with reference to FIG. 6. FIG. 6 is an explanatory view of the discharged air ingression preventive structure provided at a lower part of the rack. As illustrated in FIG. 6, a discharged air ingression preventive structure 50 is arranged to prevent an ingression of the air discharged from the rack through a gap present at a lower part of the rack 20. This structure allows preventing a "phenomenon in which the air discharged from the rack at high temperature goes directly to the air intake surface of the rack" which occurs at a position away from the ceiling opening part 30 from which cooling air is supplied.

Next, a rack side partition in a hot aisle will be explained with reference to FIG. 7. FIG. 7 is an explanatory view of a rack side partition in a hot aisle. Besides, FIG. 7 is a view seen from the ceiling side. Here, the hot aisle indicates a space between neighboring rack rows, back sides of the racks 20 arranged in the neighboring rack rows facing each other in the space.

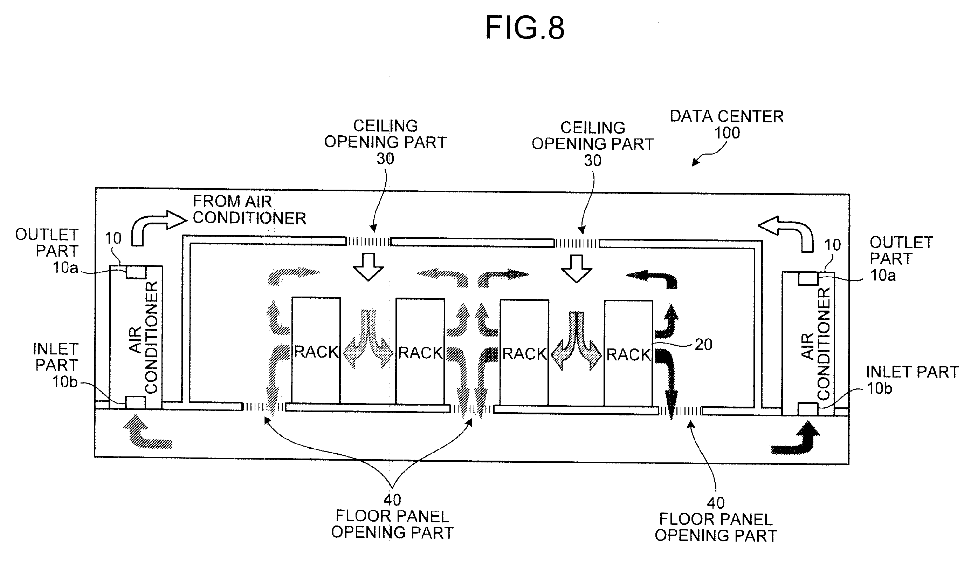

As illustrated in FIG. 7, a partition 60 is provided at a rack end in the hot aisle in the data center 100. Thus, hot air discharged from the back surface of the rack can be prevented from being discharged from the hot aisle and cool air to be supplied via the ceiling opening part 30 can be prevented from being discharged from the floor space directly through the floor panel opening part 40 without being drawn in from the front surface of the rack 20. Here, a height of the partition 60 is configured to be the same as that of the rack 20. A configuration of the data center including air conditioners is illustrated in FIG. 8.

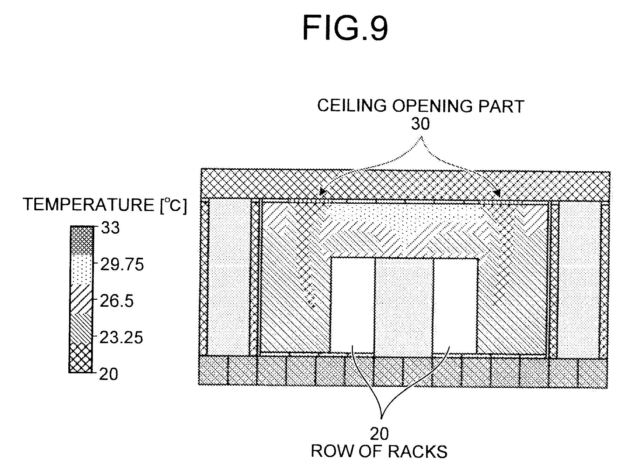

In this manner, the hot air discharged from the rack 20 and the cooling air fed from the air conditioner 10 are mixed by providing a supplying opening for cool air in the vicinity of the shunt part connecting the air discharge area and the air intake area in the data center 100, so that an air volume from the air conditioner can be reduced while keeping an intake air temperature which can be tolerated in the electronic device mounted on the rack. Here, a result of a thermal fluid simulation by which whether or not a temperature distribution in the entirety of the data center 100 is realized similarly to the simple models illustrated in FIG. 4 and 5 is verified will be explained. FIG. 9 illustrates a temperature distribution as a result of the simulation. In the simulation model illustrated in FIG. 9, the data center 100 includes two rack rows and the back surfaces of the rack rows face each other. Cool air is supplied from the ceiling opening part 30 provided over the cool aisle to the front surface of the rack.

In the example of FIG. 9, an air volume equivalent to 80% of the air volume required by the rack is supplied from the ceiling. In the hot air discharged from the rack, an air volume equivalent to 80% returns to the air conditioner by way of the underfloor plenum through the floor panel opening part provided in the hot aisle and an air volume equivalent to the rest 20% heads for the cool aisle by way of the upper part of the rack. Here, the temperature of the air to be fed from the air conditioner is set to 20°C and the temperature to go up through the rack is set to 10°C. While, when the hot air and the cool air are mixed to be an even temperature under this condition, the intake air temperature of the rack is expected to be 22.5°C, the simulation result reveals that air the temperature of which is from 22°C to 24°C is drawn in by the rack, which is not exactly to the ideal illustrated in FIGS. 4 and 5 though, and that the configuration still works sufficiently.

### Advantages Of Second Embodiment

As described so far, the data center 100 is provided with the air conditioner 10 which feeds cooling air to the space in which the racks 20 are arranged and an electronic device 20 which draws in the cooling air fed by the air conditioner 10 and discharges hot air to the air discharge area. In addition, the data center 100 is provided with the ceiling opening part 30 which is arranged in the vicinity of the shunt part along which the hot air discharged from the rack 20 flows to be drawn in into the rack 20 and supplies the cooling air fed by the air conditioner 10 to the space. When the temperature of the air from the air conditioner 10 is lower than the tolerance of the intake air temperature of the rack 20, discharged air from the rack 20 is used and allowed to mingle with the cooling air fed from the air conditioner 10, so that a volume of the cooling air from the air conditioner 10 can be suppressed and an electric power consumption can be reduced while keeping the tolerance of the intake air temperature of the rack 20.

It should be noted that the second embodiment is configured to have the partition 60 which prevents discharged air from flowing into a space of a side surface of the rack 20, the space being a shunt part not having an opening part for supplying the cooling air from the air conditioner 10 among shunt parts connecting the air discharge area to which hot air is discharged from the rack 20 and the air intake area from which air is drawn in by the rack 20. This configuration results in allowing preventing hot air discharged from the back surface of the rack 20 from being discharged from the air discharge area and from going into the air intake area without being mixed with the cooling air.

### [c] Third Embodiment

While the case of providing a ceiling opening part over the air intake area which is a space surrounded by front surfaces, i.e., air intake surfaces of the rack in the second embodiment, the present invention is not limited thereto. The ceiling opening part may be arranged over the air discharge area which is a space in which hot air discharged from the rack flows in the present invention.

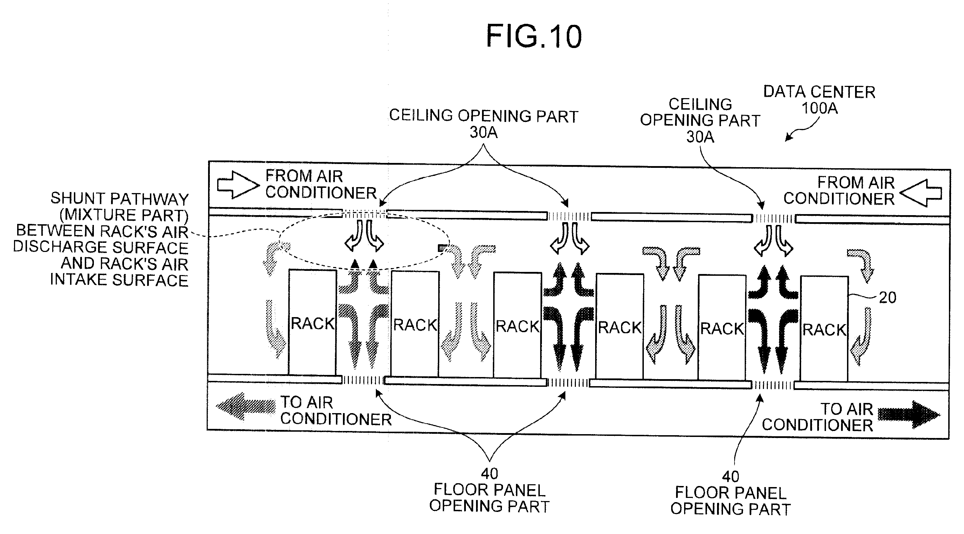

In a third embodiment to be explained below, a case of providing a ceiling opening part over the hot aisle will be explained. A configuration of a data center 100A according to the third embodiment will be explained with reference to FIG. 10. As illustrated in FIG. 10, a ceiling opening part 30A which supplies cooling air is arranged over the floor panel opening part 40 compared to the data center 100 illustrated in FIG. 3 in the data center 100A according to the third embodiment. Specifically, the ceiling opening part 30A is arranged over the air discharge area which is a space between rack rows, air discharge surfaces of the racks 20 arranged in the rack rows facing each other in the space.

In the data center 100A, the temperature of air going towards the front surface of the rack 20 is decreased by providing the ceiling opening part 30A in the vicinity of the shunt part as a flow path which connects the air discharge surface and the air intake surface and to which discharged hot air goes and by making the hot air discharged from the rack 20 combine with the cooling air fed from the air conditioner 10.

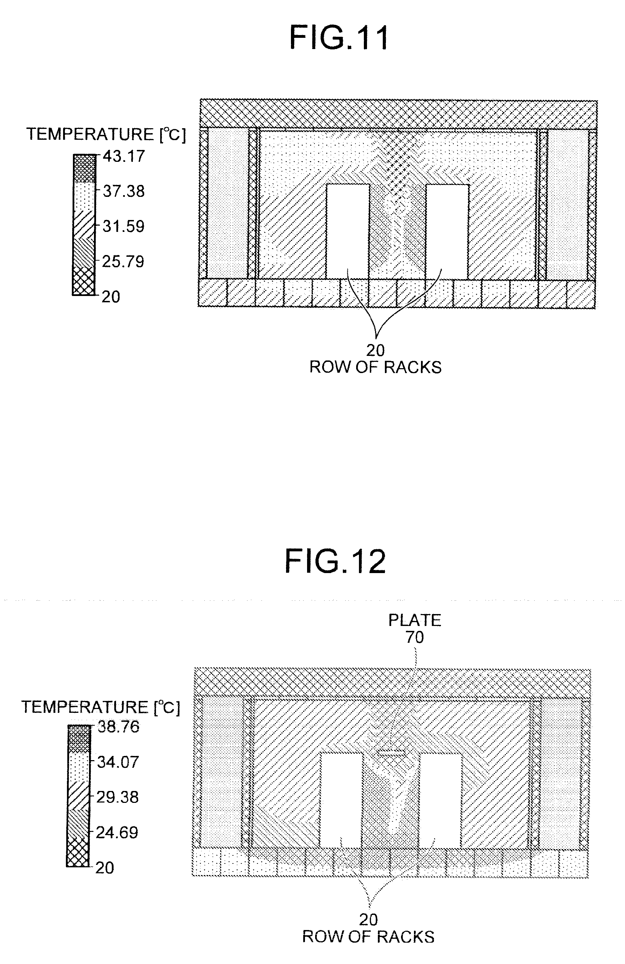

Here, a temperature distribution in an entirety of the data center 100A will be explained. FIGS. 11 to 13 illustrate simulation results. When the air coming out of the ceiling opening part 30A highly tends to travel in a straight line, a plate 70 which blocks a flow of cool air which comes in the hot aisle from the ceiling opening part 30A as illustrated in FIG. 12 may be provided since the cool air coming from the ceiling opening part 30A is drawn in directly into the floor panel opening part 40 arranged on the hot aisle and thereby an efficiency deteriorates adversely. By arranging the plate 70, the cool air coming from the ceiling opening part 30A can be prevented from being directly drawn in into the floor panel opening part 40 arranged on the hot aisle, so that the temperature of the intake air of the rack 20 can be suppressed to around 28°C.

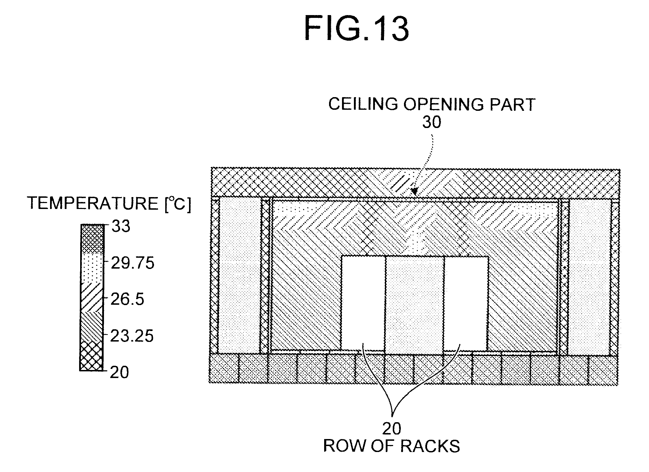

Besides, a partition may be provided at a rack end in the hot aisle similarly to the second embodiment as illustrated in FIG. 13. By arranging the partition, hot air discharged from the back surface of the rack can be prevented from being discharged from the hot aisle. In addition, the cool air supplied from the ceiling opening part 30A can be prevented from being drawn in into the floor panel opening part 40 without passing through the rack 20. Hence, the intake temperature of the rack 20 can be suppressed to 22°C to 24°C. Besides in the third embodiment, the temperature distribution in the air intake surface of the rack 20 becomes even compared to the second embodiment since the air mixture is performed from a position in the shunt part farther away from the air intake area.

As described, the ceiling opening part 30 is provided in the vicinity of the flow pathway along which the hot air discharged from the rack 20 flows to be drawn in into the rack 20 and above the space to which the hot air is discharged by the rack 20 in the third embodiment. Therefore, discharged air the temperature of which is decreased by being mixed with the cooling air can be supplied to the rack 20, a volume of the cooling air to be fed by the air conditioner 10 can be reduced, and electric power consumption can be reduced.

### [d] Fourth Embodiment

While the case of providing a supplying opening for cooling air in the vicinity of the shunt part at an upper part of the data center is explained in the first to the third embodiments described above, the present invention is not limited thereto and a supplying opening for cooling air may also be provided in the vicinity of a shunt part located at an end of a rack row.

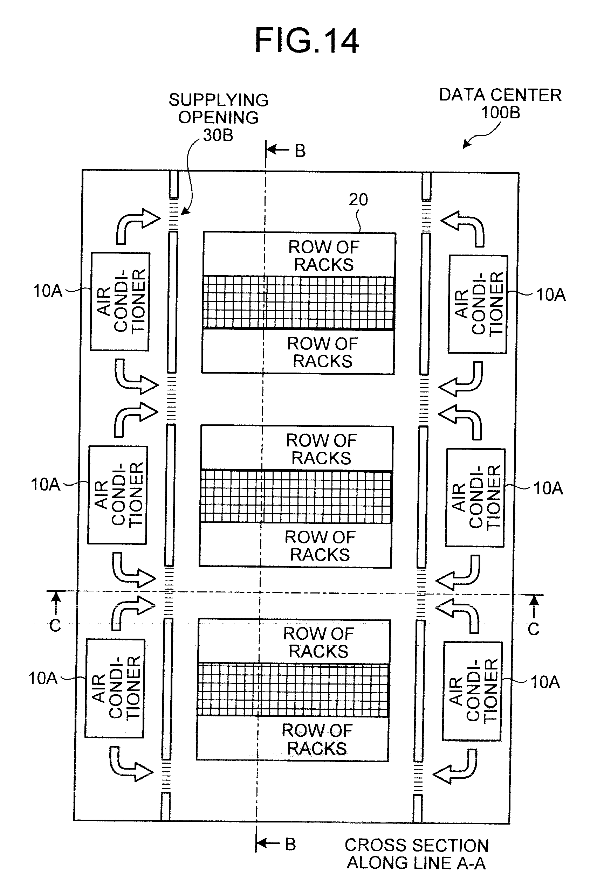

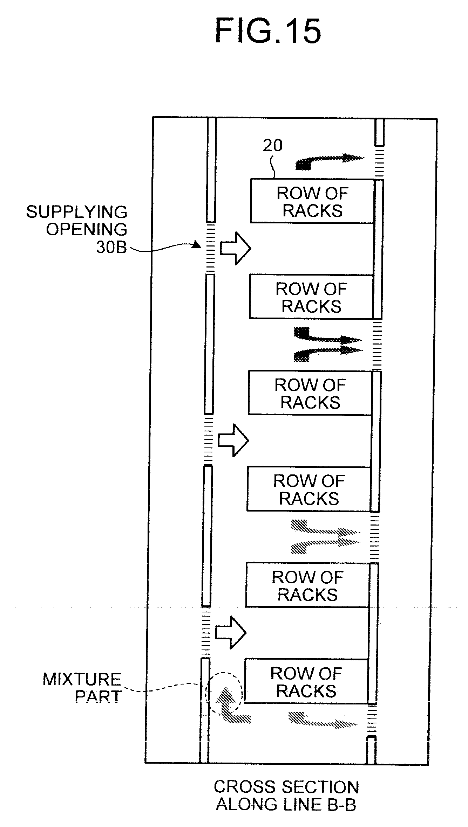

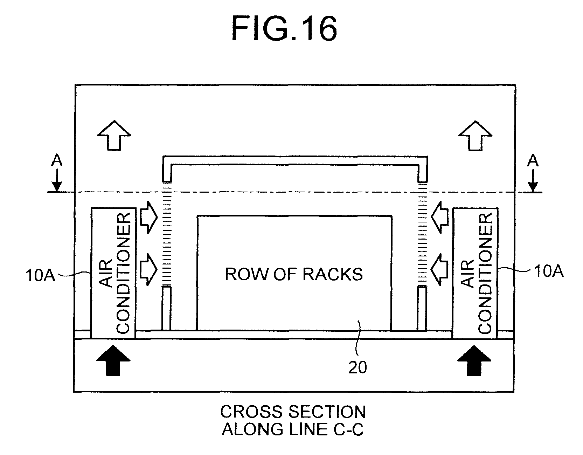

Then, as a case of providing a supplying opening for cooling air in the vicinity of a flow pathway of discharged air coming from an end of a rack row, a configuration of a data center 100B according to a fourth embodiment will be explained below with reference to FIGS. 14 to 16. FIGS. 14 to 16 are block diagrams of a configuration of the data center according to the fourth embodiment. FIG. 14 illustrates a cross section along a line A-A illustrated in FIG. 16, FIG. 15 illustrates a cross section along a line B-B illustrated in FIG. 14, and FIG. 16 illustrates a cross section along a line C-C illustrated in FIG. 14.

As illustrated in FIG. 14, a supplying opening 30B which supplies the cooling air fed from an air conditioner 10A to an over-panel floor space is arranged on a wall surface in the data center 100B. As illustrated in FIGS. 14 and 15, when an air flow volume required by the rack 20 is more than the flow volume of the cooling air fed from the air conditioner, i.e., when a volume of supplied cooling air is insufficient, a phenomenon in which hot air discharged from the back surface of the rack 20 goes to the air intake surface of the rack 20 by way of a side and an above of the rack 20 occurs.

As illustrated in FIG. 16, cooling air fed from the air conditioner 10A, in addition to being supplied from the ceiling similarly to the first to the third embodiments, is supplied to the rack rows from the supplying opening 30B arranged on the wall surface in the data center 100B. Besides, discharged hot air is, similarly to the first to the third embodiments, drawn into the under-panel space in the data center 100B.

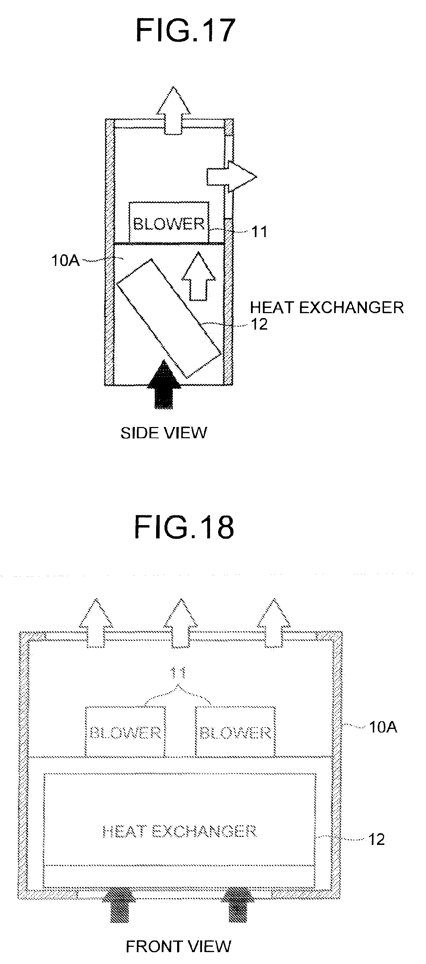

Here, the air conditioner 10A in the data center 100B will be explained with reference to FIGS. 17 and 18. FIG. 17 is a side view of the air conditioner in the data center. FIG. 18 is a front view of the air conditioner in the data center. As illustrated in FIGS. 17 and 18, the air conditioner 10A is provided with two blowers 11 and one heat exchanger 12 under the blowers 11. The blowers 11 feed cooling air from opening parts provided at an upper part and a front surface of a housing of the air conditioner 10A to the space in which the racks 20 are arranged via the ceiling opening part and the supplying opening 30B on the wall surface in the data center 100B. The heat exchanger 12 cools discharged hot air drawn in from the space under the floor panel.

As described, since the supplying opening for cooling air is arranged in the vicinity of the flow pathway of the discharged air coming from the end of rack rows, the discharged air coming from the end of rack rows can be mixed with the cooling air. As a result of this, a volume of the cooling air to be fed by the air conditioner 10 can be reduced and an electric power consumption can be reduced by supplying the mixed cooling air and discharged air to the rack 20.

### [e] Fifth Embodiment

While embodiments of the present invention are explained so far, the present invention may be achieved in various forms different from the embodiments described above. So, other embodiments included in the present invention will be explained below as a fifth embodiment.

### Partition

While the case of arranging the partition at a rack end in a hot aisle is explained in the second embodiment, the present invention is not limited thereto and a partition which can be opened and closed may be arranged at a rack end in a hot aisle.

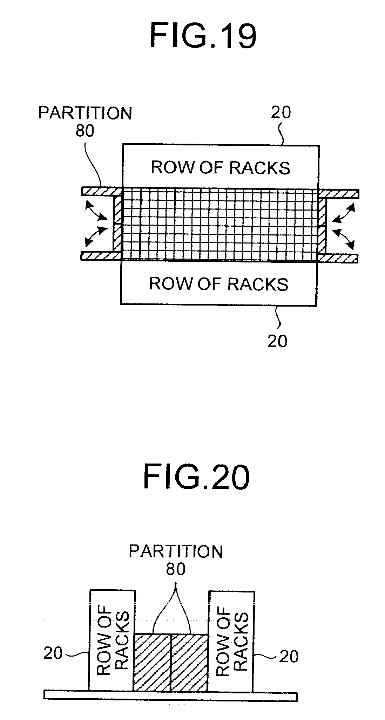

Specifically, partitions 80 are arranged at rack ends in a hot aisle as illustrated in FIG. 19 and each partition 80 is arranged so as to be opened and closed. Besides, when the partitions 80 are in a closed state as illustrated in FIG. 20, the two partitions 80 alongside block the hot aisle.

In other words, hot air discharged from the back surface of the rack can be prevented from being discharged from a hot aisle and cool air supplied from the ceiling opening part 30 can be prevented from being drawn in from the floor panel opening part 40 without passing through the rack 20 in the data center. Moreover, since the partition 80 can be opened and closed, the partition 80 can be easily opened when a maintenance person and the like enter the hot aisle.

### Cooling Air From Underfloor Space

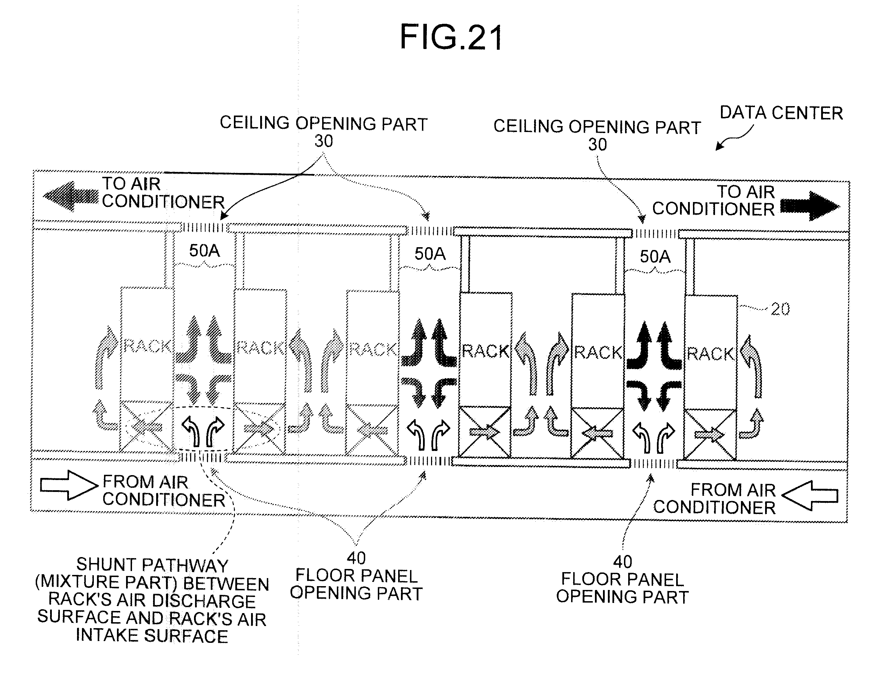

While the case of supplying cooling air from a ceiling is explained in the first to the fourth embodiments, the present invention is not limited thereto and cooling air may be supplied from an underfloor space. Specifically, a space between an upper part of the rack and a ceiling is separated by partition plates 50A as illustrated in FIG. 21. Then, the cooling air supplied from the underfloor plenum is supplied to the over-panel floor space by way of the floor panel opening part 40 and drawn in, by way of a shunt part provided at a lower part of the rack 20 after being mixed with the discharged air from the rack 20, by the rack 20. The shunt part provided at the lower part of the rack 20 is realized by a frame structure which allows a passage of air. Besides, the discharged hot air from the rack 20 returns upward to the air conditioner by way of the ceiling opening part 30 and a part of the discharged hot air goes downward to be mixed with cooling air.

Here, since the floor panel opening part 40 is provided in the vicinity of the shunt pathway in the data center as illustrated in FIG. 21, cooling air coming out of the floor panel opening part 40 is mixed in a mixture part with the air discharged at high temperature from the air discharge surface of the rack and thereby air the temperature of which is lower than a target is drawn in by all racks. Besides, an air volume to be fed from the air conditioner in the data center can be reduced by using the air discharged from the rack 20 when a temperature of the air coming out from the air conditioner is lower than a target value of an intake air temperature of the rack.

### Temperature Sensor

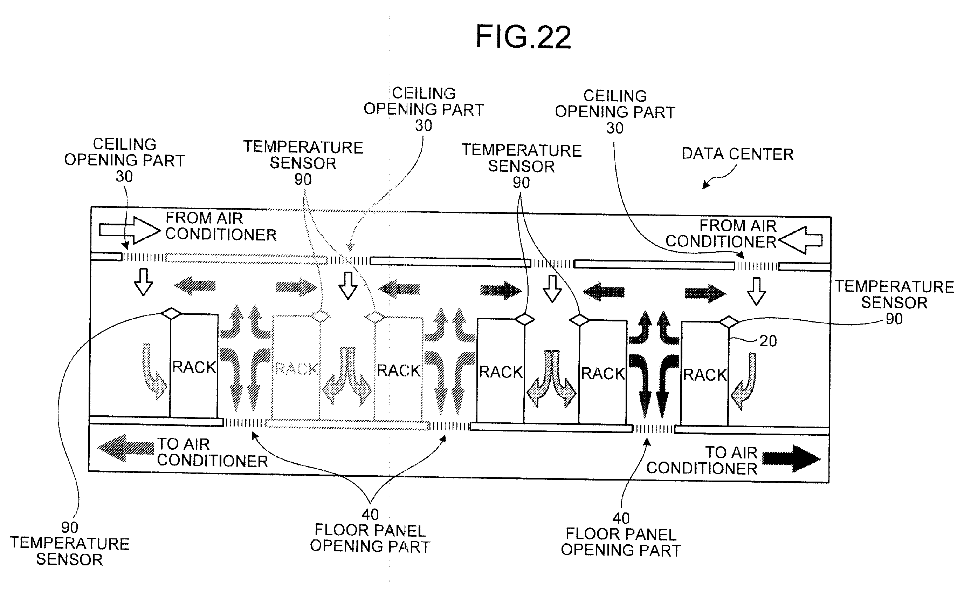

In addition, a temperature sensor may be provided in the rack as the fifth embodiment. Specifically, a temperature sensor 90 is provided at an upper part of each rack 20 as illustrated in FIG. 22. Then, the temperature sensor 90 measures a temperature of a mixture part in which the cooling air coming out of the ceiling opening part 30 is mixed with the air discharged at high temperature from the air discharge surface of the rack and notifies the measured temperature to a not illustrated air conditioner.

For example, when the temperature of the mixture part notified from the temperature sensor 90 exceeds 28°C which is a tolerance of an intake air temperature of the rack, the air conditioner controls to increase a volume of cooling air. By providing the temperature sensor in the rack, the volume of cooling air can be controlled appropriately.

## Claims

1. An air conditioning system (1), comprising:
an air conditioner (3; 10; 10A) arranged to feed cooling air to a space in which an electronic device (2) is arranged; and
a supplying opening (4; 30; 30A; 30B; 40) that is provided in a vicinity of a flow pathway along which hot air discharged from the electronic device (2) flows to be drawn into the electronic device (2) and arranged to supply the cooling air fed by the air conditioner (3; 20; 10A).

2. The air conditioning system (1) according to claim 1, further comprising a partition part (60; 80; 50A) that separates a space to which the hot air discharged from the electronic device (2) is discharged and a space from which the cooling air is drawn in by the electronic device (2).

3. The air conditioning system (1) according to claim 1 or 2, wherein the supplying opening (4; 30) is provided over the space from which the cooling air is drawn in by the electronic device (2).

4. The air conditioning system (1) according to claim 1 or 2, wherein the supplying opening (30A) is provided over the space to which the hot air discharged from the electronic device (2) is discharged.

5. The air conditioning system (1) according to any one of claims I to 3, wherein
the supplying opening (4; 30; 30A) is provided on a ceiling surface in the vicinity of the flow pathway along which the hot air discharged from the electronic device (2) flows to be drawn into the electronic device (2), and
the air conditioner (3; 10; 10A) is arranged to feed via the ceiling the cooling air to a space over a floor panel on which the electronic device (2) is arranged and to draw in the hot air discharged from the electronic device (2) from a space under the floor panel.
